# EUROPEAN PATENT APPLICATION

(11) **EP 1 120 907 A1**
(43) Date of publication of application: **01.08.2001**
(21) Application number: 00101834.0
(22) Date of filing: 29.01.2000
(51) Int. Cl.: H03G 3/30

(54) **Apparatus for amplifying signals**

(71) Applicant: SIEMENS AKTIENGESELLSCHAFT, 80333 München (DE)
(72) Inventor: Hinrichsen, Carsten, 9000 Aalborg (DK); Jensen, Niels Jorgen, 9490 Pandrup (DK)

(57) **Abstract**

The invention relates to an apparatus for amplifying signals. The apparatus exhibits a power amplifier (2) which is controlled according to a measurement of its output power by a power detector (5). The power detector (5) generates a signal according to the power measurement. The processor (7) has stored data on a calibration of the power amplifier (2) and the processor (7) compares the signal of the power detector with the stored signal to generate a signal that is used to control the output power of the power amplifier (2). The invention leads to an optimum operation of the power amplifier (2). The power detector (5) is temperature controlled and is supplied by a voltage regulator in order to eliminate voltage supply dependency.

## Description

### Prior Art

The invention relates to an apparatus for amplifying signals in accordance with the generic class of the independent claims.

It is already known to use feedback loops for power amplifiers in, for example, GSM (Global System for Mobile Communication) transmitting stations. A coupler is used to transfer a part of an output power of a power amplifier to a power detector. A circuit of a subsequent loop compares the measured power with a reference value and generates accordingly a control voltage for the power amplifier, in order to bring the power amplifier back to optimum operation conditions. This control voltage determines the output power of the power amplifier.

### Advantages of the invention

The apparatus for amplifying signals having the characterising features of the independent claims has the advantage to make full use of a dynamic range of a power amplifier. This leads to a smaller die size because for the same absolute output power a smaller power amplifier can be used if the full dynamic range is used. If the same power amplifier is used as before, then more output power of the power amplifier will be achieved. This leads to a cheaper product and to a more powerful amplifier.

A further advantage is the reduced component count due to a use of an already for other tasks employed processor as a controlling unit. This leads also to a smaller die size resulting in a cheaper and smaller product.

A further advantage of the invention is to leave a saturation area of an amplifier without delay, so that no jump the output power occurs. Such a sudden jump would result in a sharp transient and frequencies outside the given frequency band for data transmission. By avoiding this the signal power is confined to the allocated frequency band. The advantage is therefore an optimum use of the available signal power.

In addition, the invention is applicable to different modulation schemes. For GMSK (Gaussian Minimum Shift Keying) exhibiting a constant envelope and for PSK (Phase Shift Keying) exhibiting a varying envelope. This is a considerable advantage, since the invention is consequently useful for conventional GSM and for new developments in GSM technology such as Enhanced Data for GSM Evolution (EDGE) providing a considerable higher transmission rate for data transfer.

The features of the dependent claims enable further improvements of the invention.

It is an advantage of the invention to be used for wireless communication systems and wirebound communication systems.

This demonstrates the high degree of flexibility of the invention.

Furthermore, it is an advantage to compensate an output of a power detector that is used to measure a part of the output power of the power amplifier in order to reduce an influence of temperature and of noise effects on the power measurement. In this way, the processor gets only a signal according to the output power of the power amplifier.

Apart from this, it is an advantage that a voltage regulator is used for supplying the voltage for the power detector so that the power detector acts independently of the voltage supply. Therefore, variations in the power supply do not influence what the power detector detects.

### Drawings

Exemplary embodiments of the invention are shown in the figures and illustrated in the details in the description below.
Figure 1 shows a first embodiment of the invention as a block diagram of a GSM station,
figure 2 shows a burst signal
figure 3 shows a second embodiment of the invention and
figure 4 shows an integrate-and-dump network.

### Description

In many communication systems the use of a power amplifier to amplify signals which are to be sent is a standard procedure. A power amplifier as any other electrical amplifier has to be operated under optimum operating conditions. Therefore, an influence of temperature and of fluctuations of an input signal has to be minimised. The reduction of this influence demands a control circuit requiring a feedback loop.

A property of the control circuit is to measure an output signal of a to be controlled device, here it is the power amplifier, to compare a measured value with a reference value by a feedback circuit and to change an input parameter of the to be controlled device according to a difference between the measured value of the output signal and the reference value. The input parameter is here a gain of the power amplifier whereas the output signal is the output power of the power amplifier. The gain multiplied by the input power of the power amplifier gives the output power of the power amplifier.

Especially for mobile phones, an accurate control of the power amplifier in a transmitting part of a mobile phone is of high importance for the successful operation of the mobile phones. GSM is an internationally widely used standard for digital wireless cellular communications especially for mobile communications. To control, for example, the output power of a transmitting mobile phone is essential, because if the output power of the mobile phone is too large, then the battery life of the mobile phone will be sharply reduced. If the output power is too low, the signal will not be appropriately transmitted because of to many transmission errors that cannot be corrected in the receiving stations. This is due to too many bits in a digital transmission system that a wrongly detected by a receiving station. Error detecting and correcting codes which are added to information bits before transmission can only detect and correct a limited number of errors in a given number of received bits.

This is also true for other wireless communications systems and wirebound communications systems. Therefore, the invention is universally applicable, since it is useful for both applications. The optimisation of the output power of the power amplifier is of extreme importance because signal quality, a bit error rate, and an attenuation of transmitted signals are always factors that have to be considered for a communication system. The bit error rate gives the number of wrongly detected bits per received bit.

Another property is that a control loop should provide a continuous change of the control parameters, so that a change of the output power will always lead to a smooth change of the control voltage and therefore of the resulting output power. If there is sudden change causing a jump in the output power, it will lead to a generation of frequencies outside an allocated frequency band for transmitting signals of the employed communication system, since a jump, this a step function, in the time domain transferred to the frequency domain will generate an indefinite number of frequencies. Consequently, a considerable amount of power is transferred to frequencies outside the allocated frequency band for the employed communication system. This is of great importance if the power amplifier is operated in its saturation area, it is important to get the amplifier fast out of the saturation area.

For GSM (Global System for Mobile communication), GMSK (Gaussian Minimum Shift Keying) is the chosen modulation technique. GMSK is a constant envelope modulation technique using two frequencies. The envelope is constant and therefore independent of time. The error protected data as a bit stream is inspected by the modulator in groups of two successive bits. The sequences 11 and 00 are mapped to a higher of the two frequencies whereas the sequences 01 and 10 lead to the lower of the two frequencies. Thus, certain sequences in the data stream lead to certain frequencies, so that a digital frequency modulation is realised. Since two frequencies are needed, usually one local oscillator 2 is employed for generating one frequency and feeding a signal with this frequency into the modulator via its second input. A frequency doubler or tripler is used for doubling or tripling the frequency of the local oscillator to generate the other frequency. Alternatively, another local oscillator can be added to generate the second frequency or even a tuneable oscillator. These devices are connected to the modulator which performs the modulation.

After the mapping of the bit groups to the two frequencies, the created signal with the two frequencies is filtered by a Gaussian filter to smooth the transition from one frequency to the other frequency. In addition, the modulated signals are converted to radio frequencies in order to generate radio frequency signals. EDGE, however, uses 8-PSK entailing amplitude variations.

The main idea of the invention is to use a software compensation concept for controlling the power amplifier, so that the feedback loop is avoided. It is therefore a feedforward control concept and it is performed from burst to burst. In addition, a temperature compensation concept is introduced.

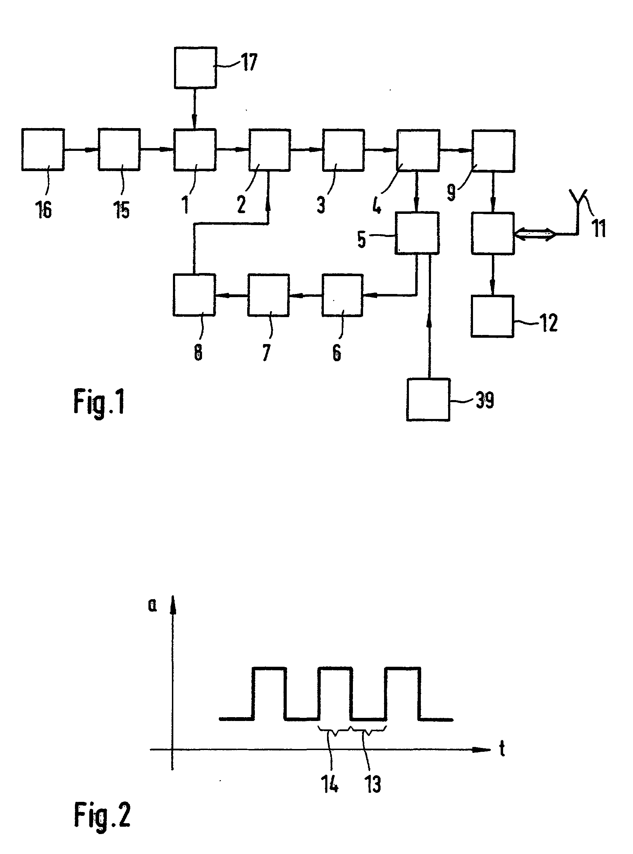

In Fig. 1 a block diagram of a GSM mobile phone with a control loop according to the invention is shown. GMSK is the modulation technique used here.

A microphone 16 converts acoustic waves into electrical signals. The electrical signals are processed by a signal processing unit 15. The signal processing unit 15 amplifies and smoothes the signal. The signal is then transferred from the signal processing unit 15 to a modulator 1. The signal coming from the signal processing unit 15 to the modulator 1 modulates a signal coming from a local oscillator 17 into the modulator 1.

The signal from the local oscillator 17 is a periodic signal with no information content, for example a sine wave, so that only information content of the signals coming from the signal processing unit 15 is impressed on the periodic signal.

The modulated signal is then transferred from the modulator 1 to a first input of a power amplifier 2. The power amplifier 2 amplifies the signals from the modulator 1 according to the control parameters which are fed into a second input of the power amplifier 2. An output of a digital-analogue converter 8 is connected to the second input of the power amplifier 2.

The amplified signal is then transferred from the power amplifier 2 to a matching network 3 which matches an output impedance of the power amplifier 2 to an input impedance of a following coupler 4 which is placed after the matching network 3. Here, the impedance is matched, so that power is not reflected back from the coupler 4 to the power amplifier 2 which will be the case if there is not the matching network 3 in between or if the output impedance of the power amplifier 2 is not equal to a complex comjugate of the input impedance of the coupler 4. In high frequency and, especially, in microwave electronics, a mismatch between the impedance of two devices leads to power reflection.

The matching network 3 exhibits a circuit consisting of reactances providing a matching input impedance for the output impedance of the power amplifier 2 and a matching output impedance for the input impedance of the coupler 4.

The coupler 4 is a device with two metallic transmission lines placed on a substrate, so that by electromagnetic coupling of the two transmission lines power is shifted from one transmission line to the other transmission line. It is called a directional coupler.

An impedance is a complex number which takes into account the resistance causing a dissipation of electrical energy and a reactance. The reactance is not responsible for the dissipation of electrical energy but it is characterized by the capacitance of a capacitor and an inductance of an inductor. A reactance can also be made of transmission lines especially at microwave frequencies. A complex conjugate of a complex number is the same real part of that complex number but the negative imaginary part of that complex number.

Alternatively, instead of a directional coupler, a collector current of the last transistor stage of the power amplifier 2 can be used as a sample of the output power of the power amplifier 2.

After the matching network 3 the signals are propagating without reflection to the coupler 4. The coupler 4 has two outputs one leading to a low pass filter 9 and the other output leading to a power detector 5. The coupler 4 divides the power of the signal into two parts: the main part, for example 99% of the total signal power, is transferred to the low pass filter 9, because this is the signal power to be sent and a maximum amount of the available signal power should be used for transmission. The second and smaller part, for example 1% of the total signal power, is transferred to the power detector 5.

The power detector 5 is a diode which is used to rectify the signals coming from the coupler 4. In this way, the power of the signal will be measured. The task of the power detector 5 is to take the average of the actual voltage waveform. The square of the voltage waveform is obtained using the current-voltage characteristic of the diode. Such a power detector is commonly called a square-law detector. The power detector 5 generates a first output signal according to the measured power.

In addition, the voltage for the power detector 5 is supplied by a voltage regulator 39 so that the dependence of the measurement of the power detector on the voltage supply is eliminated.

The voltage regulator 39 is an electronic circuit designed to provide a predetermined voltage, so that this voltage is independent of supply current, temperature and other variations. A negative feedback is used for regulating the output voltage.

The first output signal is fed into an analogue-digital converter 6 which converts the output signal of the power detector 5 into a digital signal as a second output signal, so that the following processor 7 receives the digital signal through one of its inputs from the analogue-digital converter 6.

The processor 7 compares the received digital signal with a stored digital signal as a reference to determine the difference between the received digital signal and the stored digital signal. The reference value indicates the optimum operating conditions for the power amplifier 2. If the difference between the received digital signal and the stored digital signal is zero, then the control voltage applied to the power amplifier 2 will remain unchanged because the power amplifier 2 is already operated under optimum operation conditions. A power amplifier is calibrated before it will be employed, so that its operating characteristics are known.

Thus, the difference must be zero if the power amplifier 2 is in optimum operating conditions. The processor 7 has stored a calibration curve of the power amplifier 2. This calibration curve gives the dependence of the output power of the power amplifier 2 as a function of the control voltage which is applied to the power amplifier 2. Thus, if the output power measured by the power detector 5 and transferred to the processor 7 via the analogue-digital converter 6 is below a stored value characterising the optimum operating conditions of the power amplifier 2, then the processor 7 will generate a lager control voltage than that which has been applied to the power amplifier 2. In the opposite case, if the measured output power is above the reference value, then the processor 7 will generate a lower control voltage than that which has been applied to the power amplifier 2.

In detail, the generation of the control voltage is as that: First, processor 7 generates a digital signal. This digital signal is fed into a digital-analogue converter 8 which generates an analogue control voltage according to the digital signal. The control voltage is then applied to a second input of the power amplifier 2 to determine the output power of the power amplifier 2.

The main part of the output power which passes through the low pass filter 9 to be filtered is then transferred to a switch 10. The switch 10 exhibits a transistor switch. The switch 10 switches either the output of the transmitting part of the GSM station 12 as described above or to the receiving part of the GSM station 12 to an antenna 11.

If a signal is to be sent, then the switch 10 will switch, so that the signal coming from the low pass filter 9 is passing the switch 10 and being transmitted by the antenna 11.

Alternatively, the switch 10 switches the to be transmitted signals to a modem which transmits the signals over a transmission line.

In Fig. 2, a GSM signal is shown with three time bursts as a function of time and with an amplitude a. The power detector 5 measures the power during a burst 14 and outside the burst 13 at two instants. By these two measurements the temperature compensation of the power detector 5 is performed because a power value which is measured when no burst is present is subtracted from the measured power value during a burst. This subtraction is done by the processor 7, so that the result of the subtraction is a direct measure of the output power of the power amplifier 2.

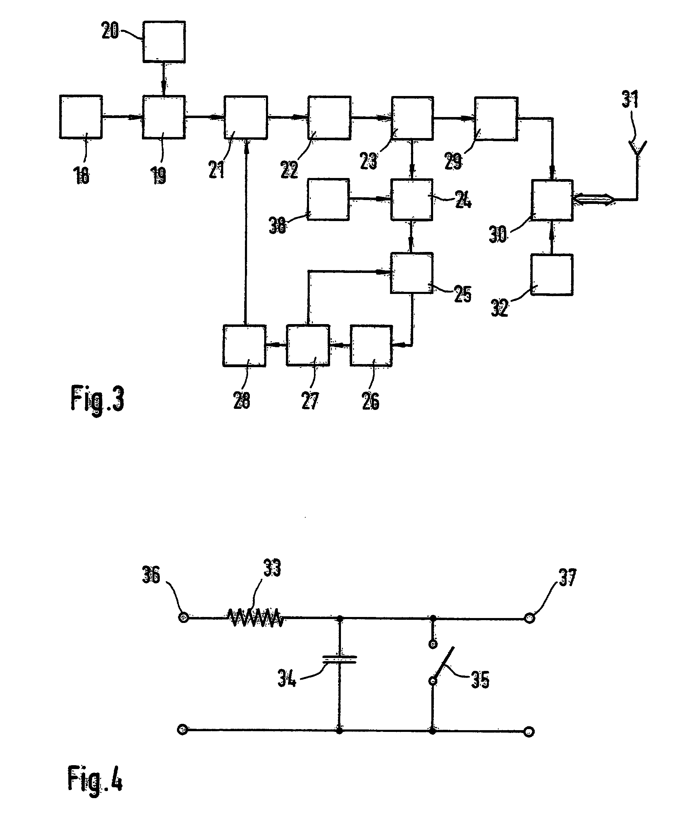

In Fig. 3, a second embodiment of the invention as a block diagram is shown. This embodiment is designed to be used for modulation techniques with a varying envelope such as 8-PSK. The function of similar elements as compared to Fig. 1 is the same.

A data source 18 is connected to a first input of a modulator 19. The data source 18 is here a microphone with attached electronics to amplify and digitise electrical signals being representative of acoustic signals.

A local oscillator 20 is connected to a second input of the modulator 19, so that the modulator 19 modulates the digitised signal. An output of the modulator 19 is connected to a first input of a power amplifier 21 in order to feed in the modulated signals, so that the power amplifier 21 amplifies the modulated signals. In addition, a digital-to-analogue converter 28 is connected to a second input of the power amplifier 21 in order to provide a control signal determining a gain factor of the power amplifier 21.

The output of the power amplifier 21 is connected to a matching network 22 providing impedance matching to a coupler 23 which is connected to the matching network 22 at the other side as described above.

A first output of the coupler 23 is connected to a low pass filter 29 and a second output to a first input of a power detector 24, the main part of the power being transferred to the low pass filter 29, since this is the power to be transmitted. The low pass filter 29 is connected to a first input of a switch 30 which is also connected via an input/output to an antenna 31. A receiver 32 is connected to a second input of the switch 30.

A second input of the power detector 24 is connected to a voltage regulator 38 providing a stable voltage supply. An output of the power detector 24 is connected to an integrate-and-dump circuit 25.

In Fig. 4, the integrate-and-dump circuit 25 is displayed in detail. An input 36 to which the output of the power detector 24 is connected is connected to a resistor 33. The resistor 33 is connected to a capacitor 34, a switch 35 and an output terminal 37. The capacitor 34 and the switch 35 are connected to mass at their other side. In operation, the capacitor 34 is charged by a current generated by the power detector 24 and flowing through the resistor 33. The switch 35 is open. By charging a capacitor a well-known integration method in circuit design is used. An integration is necessary because 8-PSK entails an amplitude variation. Since in GSM and EDGE information is transmitted in bursts, one integrates during a whole burst and then the result of the integration is an equivalent of the output power of the power amplifier.

After the burst, the switch 35 is closed, so that the capacitor 34 is discharged and ready for the next burst. The switch 35 is operated by a processor 27, so the switch 35 is connected with a first output of the processor 27.

In Fig. 3, the second input of the integrate-and-dump circuit 25 is connected to the processor 27, since the processor 27 measures the result of the integration as an second output signal after it has been digitised. Therefore, the second output signal is fed into an analogue-to-digital converter 26 converting the result to digital signal which is then fed from an output of the analogue-to-digital converter 26 to an input of the processor 27. If the digital signal stops increasing, then the processor knows that the burst is over and the processor closes the switch 35.

According to the digital signal, the processor 27 generates a control signal which is transferred via a second output to the digital-to-analogue converter 28. The output of the digital-to-analogue converter 28 is then used for controlling the power amplifier 21.

The algorithm for error correction running on the processors 7 and 27 learns by analysing the effect of the changed control signal, so that the algorithm is able to optimise its reactions to different output power levels. The algorithm is able to generate a table setting different values of the digital signal in relationship to different values for the control signal. Later when encountering values for digital signals again this table can be used for a quick generation of suitable control signals. This saves processing power of the processor.

By using a processor already used in a mobile phone one can save the circuit elements necessary for a feedback loop, at least of those which are not necessary for designing the apparatus for amplifying signals after the invention.

## Claims

1. An apparatus for amplifying signals said apparatus comprising
a power amplifier (2) amplifying the signals according to an analogue signal generated by a digital-analogue converter (8),
a coupler (4) transferring a first part of a power of the amplified signals to a device for further processing and the second part of the power of the amplified signals to a power detector (5),
the power detector (5) measuring the said second part of the power of the amplified signals and generating an output signal according to the measured power,
characterised in that said apparatus comprises
an analogue-digital converter (6) converting the output signal of the power detector (5) into a digital signal,
a processor (7) comparing the digital signal coming from the digital-analogue converter (6) with a stored digital signal and generating a digital signal according to the said comparison,
a digital-analogue converter (8) converting the digital signal generated by the processor (7) into the said analogue signal being applied to the power amplifier (2).

2. An apparatus according to claim 1 wherein the device for further processing is an antenna (11) for transmitting the signals.

3. An apparatus according to claim 1 wherein the device for further processing is a modem for transmitting the signals over a transmission line.

4. An apparatus according to claim 1 wherein the power detector (5) has means to generate an output signal without an amplified signal being present at an input of the power detector (5), so that the processor (7) compensates for temperature effects of the power detector (5) with the said output signal.

5. An apparatus according to claim 5 wherein a voltage regulator is connected to the power detector (5) for biasing the power detector (5) in order to avoid a supply voltage dependency.

6. An apparatus for amplifying signals said apparatus comprising
a power amplifier (21) amplifying the signals according to an analogue signal generated by a digital-analogue converter (28),
a coupler (23) transferring a first part of a power of the amplified signals to a device for further processing and the second part of the power of the amplified signals to a power detector (24),
the power detector (24) measuring the said second part of the power of the amplified signals and generating a first output signal according to the measured power,
characterised in that the said apparatus comprises
an integrator (25) integrating the output signal of the power detector (24) generating a second output signal thereby,
an analogue-digital converter (26) converting the second output signal into a digital signal,
a processor (27) comparing the digital signal coming from the digital-analogue converter (26) with a stored digital signal and generating a digital signal according to the said comparison,
the digital-analogue converter (28) converting the digital signal generated by the processor (27) into the said analogue signal being applied to the power amplifier (21).

7. An apparatus according to claim 6 wherein the device for further processing is an antenna (31) for transmitting the signals.

8. An apparatus according to claim 6 wherein the device for further processing is a modem for transmitting the signals over a transmission line.

9. An apparatus according to claim 6 wherein the power detector (24) has means to generate an output signal without an amplified signal being present at an input of the power detector (24), so that the processor (27) compensates for temperature effects of the power detector (24) with the said output signal.

10. An apparatus according to claim 9 wherein a voltage regulator is connected to the power detector for biasing the power detector (24) in order to avoid a supply voltage dependency.
